(19) Europäisches Patentamt

European Patent Office

Office européen des brevets

(11) Publication number: **0 229 724 B1**

## (12) EUROPEAN PATENT SPECIFICATION

(45) Date of publication of patent specification: **06.11.91** (51) Int. Cl.⁵: **G06F 3/023**

(21) Application number: **87300336.2**

(22) Date of filing: **15.01.87**

(54) **Apparatus and method for entering information into an information processing system using a keyboard.**

(30) Priority: **16.01.86 US 819442**

(43) Date of publication of application:
**22.07.87 Bulletin 87/30**

(45) Publication of the grant of the patent:
**06.11.91 Bulletin 91/45**

(84) Designated Contracting States:
**DE FR GB IT**

(56) References cited:
**WO-A-80/01725**
**US-A- 4 291 385**

**PATENT ABSTRACTS OF JAPAN, vol. 8, no. 45 (P-257)[1482], 28th February 1984; & JP-A-58 195 926 (FUJITSU K.K.) 15-11-1983**

**IBM TDB, Volume 28, No. 8, Jan. 1986, page 3601, GENERIC PERSONAL COMPUTER CHARACTER SET KEYBOARD TRANMSAC-TIONS**

(73) Proprietor: **International Business Machines Corporation**
**Old Orchard Road**
**Armonk, N.Y. 10504(US)**

(72) Inventor: **Beauregard, Gary Michael**
**4807 Avenue H**
**Austin Texas 78751(US)**
Inventor: **Bohrer, Kathryn Ann**
**3705 Del Robles**
**Austin Texas 78727(US)**
Inventor: **Leonard, Anne Gregory**
**8405 Hub Cove**
**Austin Texas 78759(US)**

(74) Representative: **Atchley, Martin John Waldeg-rave**
**IBM United Kingdom Limited Intellectual Property Department Hursley Park**
**Winchester Hampshire SO21 2JN(GB)**

# Description

This invention relates in general to arrangements for entering information into an information processing system using a keyboard.

The prior art describes various arrangements for entering information into an information processing system for storage, display, and printing of that information. In most information processing systems, a character of information is represented by an 8-bit byte, permitting 256 different permutations of bits. Each different permutation of bits can represent one information character or symbol or a control code.

Two separate systems have evolved in the art which assign specific bit permutations to a character. The first system is referred to as EBCDIC, which stands for Extended Binary Coded Decimal Interchange Code, and the second system is referred to as ASCII, which stands for American Network Standard Code for Information Interchange. The EBCDIC system is used primarily by large information processing systems, while the ASCII system is used primarily by small text processing systems and personal computer type applications.

Conventional keyboards are normally provided with about 49 or 50 keys for entering alphanumeric characters, punctuation marks, and some special symbols. Other control keys are generally also provided, such as the "shift" key, the "tab" key, etc. On some keyboards employed with personal computers, a bank of 10 function keys may also be provided and a conventional 10 key keypad may also be provided in which some keys have a dual function assigned, such as cursor movement keys, or "page-up" and "page-down" keys.

Most keyboards also include at least the standard "shift" key, which allows alpha character keys to be used for generating signals for both lower and upper case characters and allows signals for two separate symbols to be generated by some of the symbol keys. This provides for the generation of signals relating to two sets of alphanumeric characters and symbols. In some keyboard arrangements, an "alternate" key and a "control" key are also provided, each of which can be used like the shift key to generate signals relating to a third and fourth set of alphanumeric characters and symbols respectively.

Each of the keys on the keyboard is assigned a key position number, which again can be represented by an 8-bit byte. In systems which employ three separate control keys to extend the number of signals generated by each key to relate to a total of four possible characters or symbols, a total of about 196 separate characters and symbols can be entered by the keyboard into an information processing system, with the remaining keys being used for generating control code signals and various other functions.

The term "engraved keyboard' or home keyboard is used in the art to represent a set of characters and symbols that are available to the operator using a particular keyboard. In practice the designer of the system has established two tables in memory each including several code pages. One table, called the keyboard translate table, maps key positions on the keyboard and keyboard state (e.g. shift, Alt., etc) to ASCII (or EBCDIC) code points. The other table, called the display symbol table, maps each code point to a displayable symbol or control signal. In some systems, algorithms may be used instead of tables to accomplish the mapping function.

Such arrangements for entering information into an information processing system are generally adequate for a majority of the applications encountered by one user. However, the arrangements are not satisfactory if the requirements of all users are taken into consideration. Applications (e.g. foreign language, scientific etc.) may need more than the home keyboard set of characters and symbols, pushing the number of symbols required beyond the limits of a single code page of a table.

Systems such as the IBM DisplayWrite dedicated word processing system, which was marketed throughout the world for use in various applications and languages, used the "Alternate Keyboards" method to satisfy this need. In this approach a different keyboard layout or software keyboard could be substituted for the physical layout of the engraved keyboard. The new keyboard layout might be merely a rearrangement of code points from the same code page or it might use an entirely different code page which had the characters needed by the operator. However any of the new keyboard layouts, whether obtained from the base code page or a new code page, had to be from one single code page. Symbols that did not appear on the same code page could not appear on the same keyboard layout. Although the Alternate Keyboards approach was an improvement, since it allowed a different set of graphical symbols to be defined for the code points, it still limited the user to a single set of (256) code points and their predefined graphical representations. This restriction has resulted in a proliferation of code pages, as system designers attempted to group together meaningful sets of symbols for specialised applications and users.

Furthermore, since different code pages were being used to enter different information using the same key, the system had to keep track of what code page was enforced for any given sequence of operations of the keys, and output devices such as displays and printers also had to be aware of what code page was active for a particular information stream.

The storage of a large number of code pages in memory was also a problem since a large number of users could use the space in memory occupied by these pages in a more productive manner.

In addition, if the display device and printer were expected to reproduce the symbols for each set of characters and each code page included in an information stream, the functional equivalence of a code page would also have to be stored for each of these output devices.

The article in IBM Technical Disclosure Bulletin, Volume 28, No 8, January 1986, page 3601, entitled "GENERIC PERSONAL COMPUTER CHARACTER SET KEYBOARD TRANSLATIONS" describes apparatus for entering information consisting of a sequence of predetermined characters into an information processing system. The apparatus includes a keyboard having a plurality of keys selected ones of which have a plurality of operating states. This enables each such key to be used to enter two or more different characters. Signals representing the operating state of the keyboard are stored so as to provide for the signal from each key to be interpreted in accordance with the current operating state of the keyboard.

The object of the present invention is to provide an improved apparatus and method for entering information into an information system by means of a conventional keyboard which tends to avoid the above described problems that exist in the prior art information systems.

The present invention relates to apparatus for entering information consisting of a sequence of predetermined characters into an information processing system by means of a keyboard having a plurality of keys, selected ones of which have a plurality of operating states whereby each such a key can be used to enter two more different characters.

The apparatus comprises means for establishing in the information processing system a keyboard translation table having an entry for each key for each of the operating states, each such entry including a code point designation signal corresponding to the position of the associated key and a code page designation signal, the code page being a set of characters considered as a whole (e.g. on the basis of language or scientific criteria), the code page designation signal corresponding to the operating state of the keyboard and by which the code point is interpreted by the system, and means for entering into the system code point designation signals each representing a selected character in response to operating a corresponding key and code page designation signals each representing a keyboard operating state.

According to the invention the apparatus is characterised in that the means for entering comprises means for establishing in the translation table a selected number of code points from different code pages each code page corresponding to a different operating state of the keyboard, means for entering only a code point designation signal when the associated character is represented in the same code page as the previous character in the sequence, and means for entering both a code page designation signal and a code point designation signal when the associated character is represented in a different code page from the previous character in the sequence.

The present invention also relates to a method of entering information into an information processing system utilising apparatus as above. The invention is set out in apparatus-claim 1 and method-claim 4.

In order that the invention may be more readily understood an embodiment will now be described with reference to the accompanying drawings, in which:

Fig. 1 illustrates an information processing system incorporating apparatus in accordance with the present invention.

Fig. 2 illustrates one of the code tables in the system of Figure 1, and

Fig. 3, divided into Figures 3a, 3b, 3c and 3d, illustrates the structure of the data signals used in the system in Figure 1.

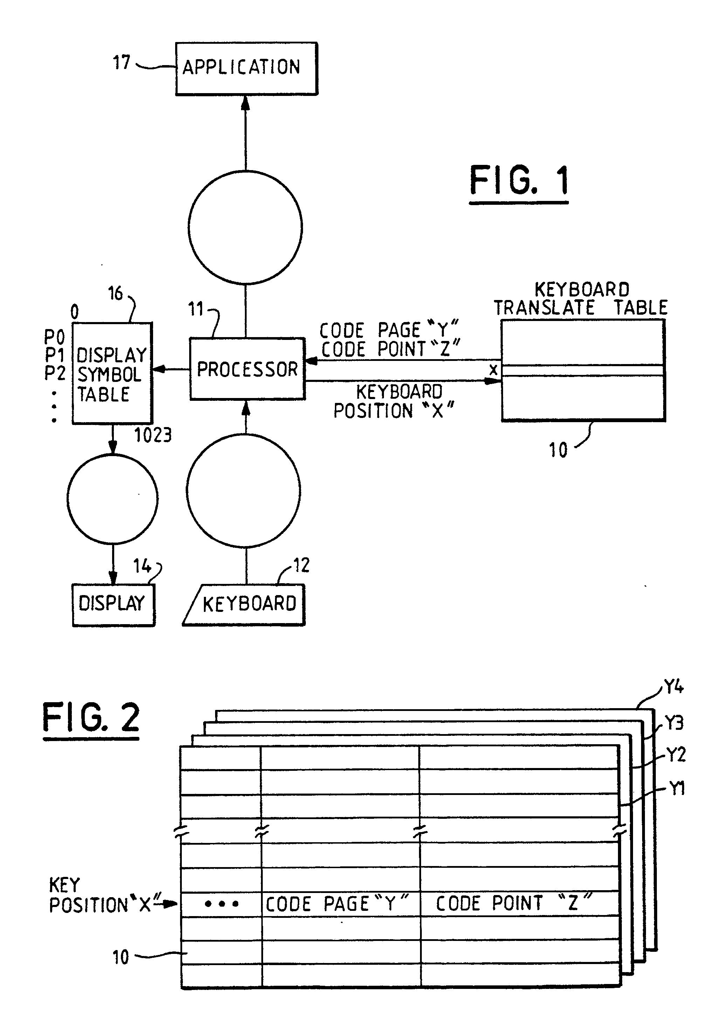

Figure 1 illustrates an information processing system with which the present invention is concerned. The processing system includes a keyboard 12, a terminal mode processor 11, a keyboard translate table 10, a display symbol table 16 and a display unit 14. The processing system also includes an application system 17 which controls the operation of the processing system.

The keyboard 12 includes a number of alphanumeric and symbol keys and four keyboard operating state control keys. The state control keys control in which of four operating states the keyboard operates so that each key can be used to enter four different characters or symbols into the processing system.

Information for processing by the information processing system is entered into the system character by character in succession by selecting, for each successive character to be entered, the corresponding alphanumeric or symbol key and the control key corresponding to the required operating state of the keyboard. Upon operation of the selected keys, a signal is transmitted via the processor 11 to the keyboard translate table 10. This table is illustrated in greater detail in Figure 2 and comprises four code pages Y1, Y2, Y3 and Y4 corresponding respectively to the four possible operating states of the keyboard. In each code page Y there are a plurality of code points Z, each corresponding to a respective one of the alphanumeric and symbol keys X on the keyboard. Therefore, for each key X, there is a corresponding code point Z in each of the code pages Y. Each code point Z will produce an output signal when it receives an input signal from the processor 11 corresponding to the associated keyboard character key X and the respective code page Y.

The input signal to the keyboard translate table 10 from the processor 11 corresponding to the operation of each key X on the keyboard 12 includes a state signal indicating by its value which state control key has been operated together with the key X. Depending on the value of this state signal so one of the four code pages Y is selected to produce an output signal corresponding to the input signal. Upon receipt by the keyboard translate table 10 of an input signal from the processor 11, the code page Y corresponding to the value of the state signal in the input signal is selected and the code point Z corresponding to the rest of the input signal is used to produce the output signal.

This output signal is supplied to the processor 11 resulting in further signals being supplied to the application system 17 and to the display symbol table 16. The display symbol table 16 comprises a plurality of code pages P0, P1... each corresponding to a different set of symbols. Included in the signal received by the table 16 from the processor 11 is a symbol set select signal which determines which one of code pages P is to be used for supplying an output signal to the display unit 14. In each code page P there are a plurality of code points each corresponding to a respective one of the alphanumeric and symbol keys X in the keyboard 12. Therefore, for each key X there is a corresponding code point $Z'$ on each of the code pages P. Each code point $Z'$ will produce an output signal when it receives an input signal from the processor 11. Each output signal from the table 16 is supplied to the display 14 and results in the display of a character or symbol corresponding to the key X which has been operated, the operating state of the keyboard and the symbol set which has been selected.

The display symbol table 16 is divided into separate code pages designated as P0, P1, P2 etc. Each code page may be conceived as a non-overlapping range of the continuum of the display symbol table. Code points x00-x1F in all code pages relate to non-displayable pseudo standard control codes 0-31. Code points x20-xFF in code page P0 relate to display symbols 32-255. The same code points in code page P1 relate to display symbols 256-479 and in code page P2 relate to display symbols 480-713. Some positions in the display symbol table are undefined by the system and are thus available for user definition, but the codes for all symbols are accessed in the same manner.

The combination of code page information and code point information supplied from the keyboard translation table 10 is used to find the correct symbol in the display symbol table 16 for display on the unit 14.

The terminal mode processor 11 maintains a keyboard mapping table which maps the operation of a key to a specific character, mode-processor defined function, or string of characters. Keystroke values can be single keystrokes or a keystroke plus accompanying depression of the shift, control, or alternate keys. All or part of this mapping table can be modified by data passed in the data signals.

The terminal mode processor 11 supplies a first set of data signals to the keyboard translate table 10 in response to input signals received from the keyboard 12. The processor also supplies a second set of data signals to the display symbol table 16 and a third set of data signals to the application system 17, both in response to input signals received from the keyboard translate table 10.

Each of these data signals normally contains code page designation data and code point designation data. In accordance with the invention the code page designation is omitted from the data signals in certain circumstances.

In a first arrangement it is assumed that one code page, termed the active code page, (Y1 or P0, for example) is to be used unless the data signal includes code page data representing another code page. In these circumstances only the code point designation data is contained in the data signal and all the input signals are supplied to the active code page. The corresponding code point data is included in the output signal. If it then becomes necessary to use a different code page Y by using a different control key on the keyboard to result in the generation of a different set of signals upon operation of each keyboard key, or to use a different code page P because a different set of symbols is to be used, then it is necessary to include a code page designation signal in the data signal.

The data signal to the keyboard translate table 10 will then include code page designation data in order to change the code page Y to be used with the code point designation data, or the data signal to the display symbol table 16 will then include code page designation data in order to change the code page P to be used with the code point designation data. In this arrangement it is necessary to include code page designation data with every code point designation data unless the code point designation data is to be associated with the active code page.

In another arrangement code page designation data representing a first code page is included in an initial data signal but omitted from subsequent data signals and all subsequently transmitted code point designation data is associated with the first code page. When the code page with which the code point designation data is to be associated is to be changed, code page designation data representing a second code page is included in one data signal. From this instant all subsequently transmitted code point designation data is associated with the second code page.

With these arrangements the user can access a character or symbol from another code page without disrupting the application output.

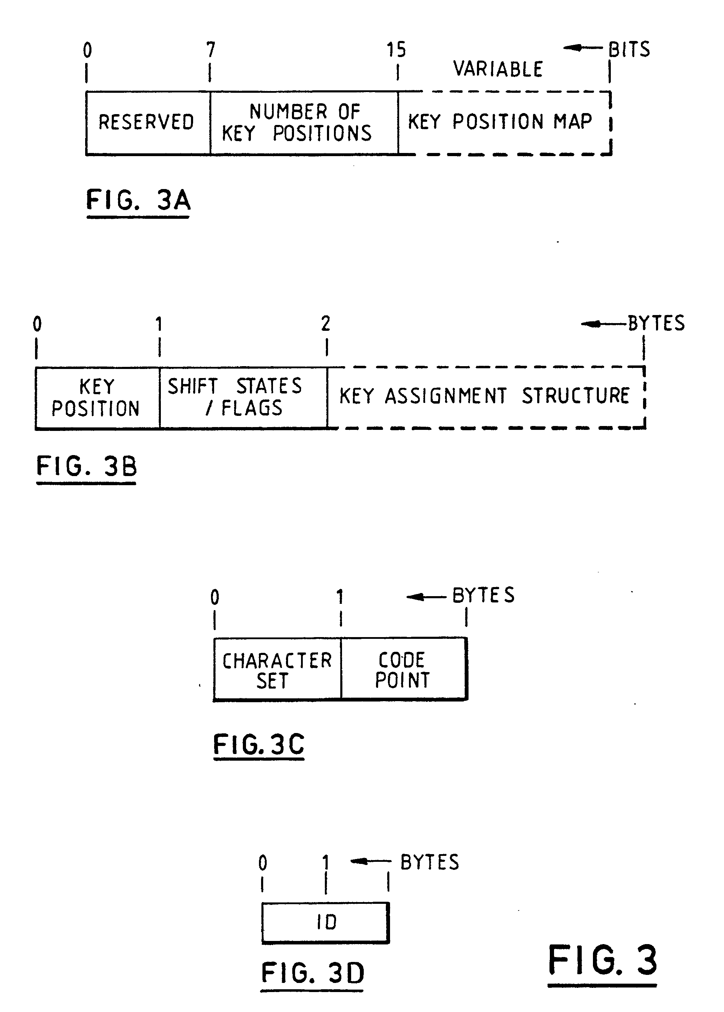

The structure of the data signals that are employed in the system described above is shown in Fig. 3.

Each data signal contains a 2-byte header. This header is followed immediately by a set of key position signals of variable length.

Each key position signal consists of three distinct signals in its bytes, dependent on the type of key assignment. All key position signals must specify a key position, the applicable shift state, and the type of key assignment.

Three types of key assignments may be included in a signal. The method of the present invention is directed specifically to character remapping. The signal requirements for each character signal are as follows:

. Single character signal:
  . Key position
  . Shift state
  . Code page
  . Code point.

The signal types may be freely mixed, but the number of signals must match the number of key positions.

The fields in the header are illustrated in Figure 3a and are defined as follows:

. Number of key positions
  This value is the number of key positions to be mapped.
. Key position maps
  This field contains the new mappings of key position to symbol or function.

Fig. 3b expands on the key position maps field of Fig. 3a.

The fields shown in Fig. 3b are defined as follows:

. Key position

The key position field contains the keyboard position to remap. Each key on the keyboard has a numeric position code that is used for this field.

. Shift states
  Bit 0 (caps lock) =
  0  - Caps lock has no effect.
  1  - Shifted state in effect when pressed.
. Bits 1-2
  The binary value of bits 1-2 indicates whether the new key assignment applies to the key in the base, shift, control, or alternate state.
. Flags
  The binary value of bits 4-7 indicates the type of key assignment.
  0000 = A character is assigned to this key position. Bytes 3 and 4 contain a character set and code point for this field.

When the flags field = 0000 (character), the key assignment structure shown in Fig. 3c is defined as follows:

Character set - The PCASCII character set from which the display symbol is taken.

Code point - The code point within the specified PCASCII character set.

The information processing system described above includes a keyboard translate table which may or may not contain code points from different code pages, depending on the language of the system keyboard. Therefore, no application action is necessary to use the arrangement of multiple concurrent code pages on a keyboard. However if an application wishes to access from the keyboard a greater variety of characters and symbols than anticipated by the system designer of a keyboard layout, it may freely do so by altering the keyboard translate map in the manner described above. For example, the user of a German keyboard layout would be using code points from different code pages without having to make the above described alterations because the German keyboard layout already has such mixed code pages. However the German user might want to modify the keyboard to include other special characters contained in the display symbol table. The system described allows the user to add these characters or symbols without regard to remaining within the bounds of a single code page.

In order to utilise the information processing system described above, the keyboard translation table 10 is initially set up using data from the application system 17. Character data is then entered into the system, as illustrated in Fig. 1.

As shown in Fig. 1, the keyboard 12 is connected to the terminal mode processor 11. When a key is struck, the position code is generated and transferred to the processor 11. The processor 11 functions to translate the key position code to a code page and code point by reading out the entry in the keyboard translate table 10, to which the key position code may have been assigned during the first phase of the operation discussed in connection with Fig. 1.

The data is then sent to the application and display device 14 as described below.

The datastream sent by the processor 11 must include information to identify the code page in table 10 and the character set or code page in table 16 that should be used in interpreting the byte of data represented in the code point.

Two slightly different arrangements are described for identifying the code page. The first technique for notifying the application of the code page involves the assumption that the default code page P0 or the active code page set by the application is to be used until further notification is received of a code page single shift (SS) code. The application assumes that, as long as the characters are in an active code page, only 8-bit bytes are sent. When a character that is not in the active code page is keyed, the mode processor sends both a single shift code and the 8-bit byte or code point. The code point is then interpreted by the application according to the new code page designated by the single shift code. Subsequent characters are interpreted based on the active code page. Thus, the single shift codes are nonlocking, in that they apply only to the immediately following subsequent character.

In the second technique, an active character set is assumed, as before. If a character in the datastream comes from a different code page, a page notifier control sequence is inserted which changes the active keyboard code page. This new code page stays active until a code point from another code page is entered via the keyboard. Thus, if only one character in a sequence of characters is in a different code page, two control sequences must be sent by the datastream; one prior to the character and one after.

The terminal mode processor 11 may also send display symbols to the display device 14 in accordance with the data obtained from the keyboard translation table. The code point is translated according to its defined code page into a 10-bit display symbol.

The method of operation described, in effect, logically disconnects the keyboard 12 from the output datastream which provides considerable advantages to the operator in terms of structuring keyboards that are most advantageously employed for his particular application.

Considerable storage is also saved, in that there is no duplication of characters which were common to several code pages in systems employed by the prior art. Also, in certain applications requiring keyboard or character set changes, the amount of data carried by a datastream is reduced in accordance with the present method.

## Claims

1. Apparatus for entering information consisting of a sequence of predetermined characters into an information processing system by means of a keyboard (12) having a plurality of keys, selected ones of which have a plurality of operating states whereby each such a key can be used to enter two more different characters, comprising

    means for establishing in said information processing system a keyboard translation table (10) having an entry for each key for each of said operating states, each said entry including a code point designation signal corresponding to the position of the associated key and a code page designation signal, said code page being a set of characters considered as a whole (e.g. on the basis of language or scientific criteria), said code page designation signal corresponding to the operating state of the keyboard and by which said code point is interpreted by said system, and

    means for entering into said system code point designation signals each representing a selected character in response to operating a corresponding key and code page designation signals each representing a keyboard operating state,

    characterised in that said means for entering comprises

    means (17, 11) for establishing in said translation table a selected number of code points from different code pages each code page corresponding to a different operating state of said keyboard,

    means (10, 11, 16, 17) for entering only a code point designation signal when the associated character is represented in the same code page as the previous character in the sequence, and

    means (10, 11, 16, 17) for entering both a code page designation signal and a code point designation signal when the associated character is represented in a different code page from the previous character in the sequence.

2. Apparatus as claimed in claim 1 characterised in that it comprises means for generating a unique keyboard position signal in response to operating each key and means (11) for supplying said position signal to said translation table (10) to cause said designation signals to be read out to said system.

3. Apparatus as claimed in claim 2 characterised in that it comprises means (11) for designating an active code page prior to entry of information into said system, and means for entering both designation signals into said system whenever the character being entered is not associated with the active code page.

4. A method of entering information consisting of a sequence of predetermined characters into an information processing system by means of a keyboard (12) having a plurality of keys, selected ones of which have a plurality of operating states whereby each such a key can be used to enter two more different characters, comprising

 establishing in said information processing system a keyboard translation table (10) having an entry for each key for each of said operating states, each said entry including a code point designation signal corresponding to the position of the associated key and a code page designation signal, said code page being a set of characters considered as a whole (e.g. on the basis of language or scientific criteria), said code page designation signal corresponding to the operating state of the keyboard and by which said code point is interpreted by said system, and

 entering into said system code point designation signals each representing a selected character in response to operating a corresponding key and code page designation signals each representing a keyboard operating state,

 characterised in that said entering operation comprises

 establishing in said translation table a selected number of code points from different code pages, each code page corresponding to a different operating state of said keyboard,

 entering only a code point designation signal when the associated character is represented in the same code page as the previous character in the sequence, and

 entering both a code page designation signal and a code point designation signal when the associated character is represented in a different code page from the previous character in the sequence.

5. A method as claimed in claim 4 characterised in that it comprises generating a unique keyboard position signal in response to operating each key and supplying said position signal to said translation table to cause said designation signals to be read out to said system.

6. A method as claimed in claim 5 characterised in that it comprises designating an active code page prior to entry of information into said system, and entering both designation signals into said system whenever the character being entered is not associated with the active code page.

**Revendications**

1. Dispositif pour entrer une information constituée par une séquence de caractères prédéterminés dans un système de traitement d'informations à l'aide d'un clavier (12) possédant une pluralité de touches, dont certaines sélectionnées possèdent une pluralité d'états de fonctionnement, ce qui a pour effet que chaque touche de ce type peut être utilisée pour entrer plus de deux caractères différents, comprenant

 des moyens pour établir, dans ledit système de traitement d'informations, une table de conversion de clavier (10) possédant une entrée pour chaque touche pour chacun desdits états de fonctionnement, chacune desdites entrées comprenant un signal de désignation d'un point de code correspondant à la position de la touche associée et un signal de désignation d'une page de code, ladite page de code étant un ensemble de caractères considérés dans leur ensemble (c'est-à-dire sur la base d'un langage ou de critères scientifiques), ledit signal de désignation de la page de code correspondant à l'état de fonctionnement du clavier, et au moyen duquel ledit point de code est interprêté par ledit système, et

 des moyens pour entrer, dans ledit système, des signaux de désignation de points de code, dont chacun représente un caractère sélectionné en réponse au traitement d'un code correspondant, et des signaux de désignation de pages de codes, dont chacun représente un état de fonctionnement du clavier,

 caractérisé en ce que lesdits moyens d'entrée comprennent

des moyens (17,11) pour établir, dans ladite table de conversion, un nombre sélectionné de points de code à partir de différentes pages de codes, dont chacune correspondant à un état de fonctionnement différent dudit clavier,

des moyens (10,11,16,17) pour entrer seulement un signal de désignation d'un point de code, lorsque le caractère associé est représenté par la même page de code que le caractère précédent dans la séquence, et

des moyens (10,11,16,17) pour entrer à la fois un signal de désignation de page de code et un signal de désignation de point de code, lorsque le caractère associé est représenté avec une page de code différente du caractère précédent de la séquence.

2. Dispositif selon la revendication 1, caractérisé en ce qu' il comprend des moyens pour produire un signal unique de position de clavier en réponse à l'actionnement de chaque touche, et des moyens (11) pour envoyer ledit signal de position à ladite table de conversion (10) pour provoquer la délivrance desdits signaux de désignation audit système.

3. Dispositif selon la revendication 2, caractérisé en ce qu'il comprend des moyens (11) pour désigner une page de code active avant l'entrée de l'information dans ledit système, et des moyens pour entrer les deux signaux de désignation dans ledit système chaque fois que le caractère entré n'est pas associé à la page de code active.

4. Procédé d'entrée d'informations constituée par une séquence de caractères prédéterminés dans un système de traitement d'informations à l'aide d'un clavier (12) possédant une pluralité de touches, dont certaines sélectionnées possèdent une pluralité d'états de fonctionnement, ce qui a pour effet que chaque touche de ce type peut être utilisée pour entrer plus de deux caractères différents, comprenant

l'établissement, dans ledit système de traitement d'informations, d'une table de conversion de clavier (10) possédant une entrée pour chaque touche pour chacun desdits états de fonctionnement, chacune desdites entrées comprenant un signal de désignation d'un point de code correspondant à la position de la touche associée et un signal de désignation d'une page de code, ladite page de code étant un ensemble de caractères considérés dans leur ensemble (c'est-à-dire sur la base d'un langage ou de critères scientifiques), ledit signal de désignation de la page de code correspondant à l'état de fonctionnement du clavier, et au moyen duquel ledit point de code est interposé par ledit système, et

l'entrée, dans ledit système, de signaux de désignation de points de code, dont chacun représente un caractère sélectionné en réponse au traitement d'un code correspondant, et de signaux de désignation de pages de codes, dont chacun représente un état de fonctionnement du clavier,

caractérisé en ce que ladite opération d'entrée comprend

l'établissement, dans la table de conversion, d'un nombre sélectionné de points de code à partir de différentes pages de codes, dont chacune correspondant à un état de fonctionnement différent dudit clavier,

l'entrée de seulement un signal de désignation d'un point de code, lorsque le caractère associé est représenté par la même page de code que le caractère précédent dans la séquence, et

l'entrée à la fois d'un signal de désignation de page de code et d'un signal de désignation de point de code, lorsque le caractère associé est représenté avec une page de code différente du caractère précédent de la séquence.

5. Procédé selon la revendication 4, caractérisé en ce qu'il comprend la production d'un signal unique de position de clavier en réponse à l'actionnement de chaque touche, et l'envoi dudit signal de position à ladite table de conversion pour provoquer la délivrance desdits signaux de désignation audit système.

6. Procédé selon la revendication 5, caractérisé en ce qu'il comprend la désignation une page de code active avant l'entrée d'une information dans ledit système, et l'entrée des deux signaux de désignation dans ledit système chaque fois que le caractère entré n'est pas associé à la page de code active.

**Patentansprüche**

1. Einrichtung zum Eingeben von eine Folge vorbestimmter Zeichen beinhaltenden Informationen in ein Informationsverarbeitungssystem mittels einer Tastatur (12) mit einer Mehrzahl von Tasten, bei welchen ausgewählte eine Mehrzahl von Betriebszuständen aufweisen, wodurch jede solche Taste verwendet werden kann, um zwei oder mehr verschiedene Zeichen einzugeben, mit:

Mitteln zum Herstellen einer Tastatur-Übersetzungstabelle (10) in dem Informationsverarbeitungssystem, die einen Eintrag für jede Taste für jeden der Betriebszustände aufweist, wobei jeder Eintrag ein Codestelle-Kennzeichnungssignal, welches der Position der zugeordneten Taste entspricht und ein Codeseite-Kennzeichnungssignal aufweist, wobei die Codeseite ein Satz von als ein ganzes betrachteten Zeichen ist (z.B. auf der Basis von sprachlichen oder wissenschaftlichen Kriterien), das Codeseite-Kennzeichnungssignal dem Betriebszustand der Tastatur entspricht und wodurch die Codestelle von dem System interpretiert wird und

einem Mittel zum Eingeben von Codestelle-Kennzeichnungssignalen in das System, wobei jedes ein ausgewähltes Zeichen entsprechend dem Betätigen einer entsprechenden Taste repräsentiert und von Codeseite-Kennzeichnungssignalen, wobei jedes einen Tastatur-Betriebszustand repräsentiert,

dadurch gekennzeichnet, daß das Mittel zum Eingeben aufweist:

Mittel (17, 11) zum Herstellen einer ausgewählten Anzahl von Codestellen in der Übersetzungstabelle aus verschiedenen Codeseiten, wobei jede Codeseite einem verschiedenen Betriebszustand der Tastatur entspricht,

Mittel (10, 11, 16, 17) zum Eingeben nur eines Codestelle-Kennzeichnungssignals, wenn das zugeordnete Zeichen auf derselben Codeseite repräsentiert ist, wie das vorangehende Zeichen in der Folge und

Mittel (10, 11, 16, 17) zum Eingeben sowohl eines Codeseite-Kennzeichnungssignals als auch eines Codestelle-Kennzeichnungssignals, wenn das zugeordnete Zeichen auf einer verschiedenen Codeseite aus dem vorangehenden Zeichen in der Folge repräsentiert ist.

2. Einrichtung nach Anspruch 1, dadurch gekennzeichnet, daß sie aufweist: Mittel zum Erzeugen eines eindeutigen Tastaturpositionssignals entsprechend dem Betätigen jeder Taste und Mittel (11) zum Liefern des Positionssignals an die Übersetzungstabelle (10), um zu bewirken, daß die Kennzeichnungssignale an das System herausgelesen werden.

3. Einrichtung nach Anspruch 2, dadurch gekennzeichnet, daß sie aufweist: Mittel (11) zum Kennzeichnen einer aktiven Codeseite vor dem Eintragen von Informationen in das System und Mittel zum Eingeben beider Kennzeichnungssignale in das System, jedesmal wenn das eingegebene Zeichen der aktiven Codeseite nicht zugeordnet ist.

4. Verfahren zum Eingeben von eine Folge vorbestimmter Zeichen beinhaltenden Informationen in ein Informationsverarbeitungssystem mittels einer Tastatur (12) mit einer Mehrzahl von Tasten, bei welchen ausgewählte eine Mehrzahl von Betriebszuständen aufweisen, wodurch jede solche Taste verwendet werden kann, um zwei oder mehr verschiedene Zeichen einzugeben, das umfaßt:

Herstellen einer Tastatur-Übersetzungstabelle (10) in dem Informationsverarbeitungssystem, die einen Eintrag für jede Taste für jeden der Betriebszustände aufweist, wobei jeder Eintrag ein Codestelle-Kennzeichnungssignal, welches der Position der zugeordneten Taste entspricht und ein Codeseite-Kennzeichnungssignal aufweist, wobei die Codeseite ein Satz von als ein ganzes betrachteten Zeichen ist (z.B. auf der Basis von sprachlichen oder wissenschaftlichen Kriterien), das Codeseite-Kennzeichnungssignal dem Betriebszustand der Tastatur entspricht und wodurch die Codestelle von dem System interpretiert wird und

Eingeben von Codestelle-Kennzeichnungssignalen in das System, wobei jedes ein ausgewähltes Zeichen entsprechend dem Betätigen einer entsprechenden Taste repräsentiert und von Codeseite-Kennzeichnungssignalen, wobei jedes einen Tastatur-Betriebszustand repräsentiert,

dadurch gekennzeichnet, daß der Arbeitsgang zum Eingeben umfaßt:

Herstellen einer ausgewählten Anzahl von Codestellen in der Übersetzungstabelle aus verschiedenen Codeseiten, wobei jede Codeseite einem verschiedenen Betriebszustand der Tastatur entspricht,

Eingeben nur eines Codestelle-Kennzeichnungssignals, wenn das zugeordnete Zeichen auf derselben Codeseite repräsentiert wird, wie das vorangehende Zeichen in der Folge und

Eingeben sowohl eines Codeseite-Kennzeichnungssignals als auch eines Codestelle-Kennzeichnungssignals, wenn das zugeordnete Zeichen auf einer verschiedenen Codeseite aus dem vorangehenden Zeichen in der Folge repräsentiert wird.

5. Verfahren nach Anspruch 4, dadurch gekennzeichnet, daß dieses umfaßt: Erzeugen eines eindeutigen Tastaturpositionssignals entsprechend dem Betätigen jeder Taste und Liefern des Positionssignals an die Übersetzungstabelle, um zu bewirken, daß die Kennzeichnungssignale an das System herausgelesen werden.

6. Verfahren nach Anspruch 5, dadurch gekennzeichnet, daß dieses umfaßt: Kennzeichen einer aktiven Codeseite vor dem Eintragen von Informationen in das System und Eingeben beider Kennzeichnungssignale in das System, jedesmal wenn das eingegebene Zeichen der aktiven Codeseite nicht zugeordnet ist.

FIG. 1

FIG. 2

11

FIG. 3A

FIG. 3B

FIG. 3C

FIG. 3D

FIG. 3